# FASCICULE DE BREVET EUROPEEN

(11) **EP 0 491 589 B1**
(45) Date de publication et mention de la délivrance du brevet: **01.02.1995**
(21) Numéro de dépôt: 91403199.2
(22) Date de dépôt: 26.11.1991
(51) Int. Cl.: F02P 3/08, F02P 15/00, H02M 9/04, H03K 3/57, H03K 4/02, F02C 7/266

(54) **Générateur d'allumage haute énergie notamment pour turbine à gaz**
Zündungsgenerator von hoher Energie z.B. für Gasturbine
Ignition generator of high energy e.g. for gas turbine

(30) Priorité: 19.12.1990 FR 9015944
(43) Date de publication de la demande: 24.06.1992
(73) Titulaire: LABO INDUSTRIE, F-92002 Nanterre Cédex (FR)
(72) Inventeur: Balland, Patrick Guy André, F-92500 Rueil Malmaison (FR)
(74) Mandataire: Habasque, Etienne Joel Jean-François

(56) Documents cités:
- EP-A- 0 362 014
- US-A- 3 635 202
- US-A- 3 832 986
- US-A- 4 967 037

## Description

La présente invention concerne un perfectionnement au générateur d'allumage haute énergie, notamment pour turbine à gaz, décrit dans la demande de brevet 88 12 272 au nom de la Demanderesse (EP-A-0 362 014).

Cette demande décrit un générateur d'allumage haute énergie du type comportant une source d'énergie munie d'un transformateur dont un enroulement secondaire est raccordé à un premier circuit comprenant un condensateur de stockage d'énergie, une inductance et une bougie d'allumage, en série, une diode de roue libre étant reliée en parallèle aux bornes de l'inductance et de la bougie d'allumage et des moyens de court-circuitage du premier circuit de manière à engendrer des étincelles entre les électrodes de la bougie, dans lequel les moyens de court-circuitage comprennent au moins un organe commutateur à semi-conducteur commandé par des moyens de comparaison de la tension aux bornes du condensateur de stockage à une valeur de référence et des moyens de commande de la charge du condensateur à un premier rythme pendant une première période de temps et à un second rythme pendant une seconde période de temps, le second rythme étant supérieur au premier, sont interposés entre la source d'énergie et le premier circuit.

Dans le mode de réalisation décrit dans la demande précitée, les moyens de comparaison de la tension aux bornes du condensateur du premier circuit à la tension de référence, sont reliés directement aux bornes de ce condensateur.

Ceci présente un certain nombre d'inconvénients dans la mesure où il est nécessaire de créer une source d'alimentation secondaire pour ces moyens de comparaison et où il n'y a pas d'isolation galvanique entre ces deux parties du générateur.

Le but de l'invention est donc de résoudre ces problèmes en proposant une variante de réalisation de ce générateur, qui permette d'isoler galvaniquement ces deux parties de celui-ci, et qui soit simple et fiable.

A cet effet, l'invention a pour objet un générateur tel que décrit précédemment, caractérisé en ce que les moyens de comparaison de la tension aux bornes du condensateur du premier circuit à la tension de référence, sont reliés aux bornes d'un condensateur d'un second circuit comprenant en série au moins ce condensateur et une impédance, connecté aux bornes d'un autre enroulement secondaire du transformateur, ce second circuit étant équivalent au premier, de manière que la tension aux bornes du condensateur de ce second circuit soit l'image de celle aux bornes du condensateur du premier circuit.

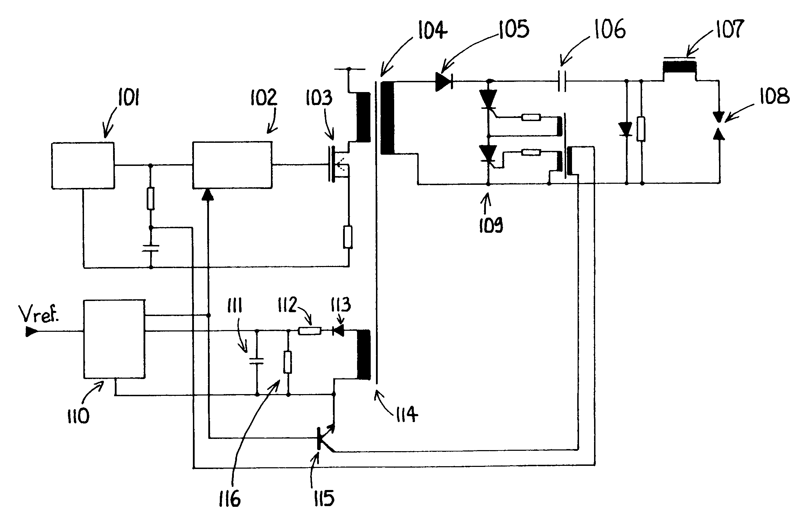

L'invention sera mieux comprise à l'aide de la description qui va suivre, donnée uniquement à titre d'exemple et faite en se référant au dessin annexé, qui représente un schéma synoptique d'un générateur selon l'invention.

On reconnaît sur cette figure, la structure générale d'un générateur tel que décrit dans la demande précitée.

Ce générateur comporte en effet une source d'énergie comprenant une alimentation 101 permettant de déclencher à travers un circuit d'excitation 102, un transistor 103 d'alimentation de l'enroulement primaire d'un transformateur 104 équivalent au transformateur 7 décrit dans la demande précitée.

Un premier enroulement secondaire de ce transformateur est relié à un premier circuit comprenant en série une diode 105, un condensateur de stockage d'énergie 106, une inductance 107 et une bougie d'allumage 108.

Des moyens 109 de court-circuitage de ce premier circuit, sont également prévus de manière à engendrer des étincelles entre les électrodes de la bougie.

Ces moyens de court-circuitage présentent une structure analogue à celle des moyens équivalents décrits dans la demande précitée et comprennent au moins un organe commutateur à semi-conducteur commandé par des moyens de comparaison 110 de la tension aux bornes du condensateur 106 du premier circuit à une tension de référence.

Le circuit d'excitation 102 permet de contrôler la charge du condensateur 106 du premier circuit à un premier rythme pendant une première période de temps et à un second rythme pendant une seconde période de temps, le second rythme étant supérieur au premier, comme cela est expliqué dans la demande précitée.

Alors que dans le mode de réalisation décrit dans la demande précitée, la tension aux bornes du condensateur 106 de ce premier circuit est prélevée directement aux bornes de ce condensateur, dans la variante de réalisation faisant l'objet de la présente demande, cette tension est prélevée aux bornes d'un condensateur 111 d'un second circuit comprenant en série, au moins ce condensateur 111 et une impédance 112 comprenant par exemple une résistance et/ou une inductance en fonction de la fréquence de travail. Ce second circuit est connecté à travers une diode 113 aux bornes d'un second enroulement secondaire 114 du transformateur 104. Ce second circuit est équivalent du point de vue électrique au premier circuit, de manière que la tension aux bornes du condensateur 111 de ce second circuit soit l'image de celle aux bornes du condensateur 106 du premier circuit.

En effet, du fait que la charge du transformateur est essentiellement capacitive, la tension de sortie du premier enroulement de ce transformateur est égale à la tension de charge du condensateur du premier circuit à chaque instant. Dans le cas où le second circuit est équivalent du point de vue électrique au premier, la tension aux bornes du condensateur de ce second circuit est donc l'image de la tension aux bornes du condensateur du premier circuit, ce qui permet d'utiliser un moyen indirect pour obtenir la tension aux bornes du condensateur du premier circuit, tout en réalisant une isolation galvanique de ces deux parties du générateur.

La sortie des moyens de comparaison 110 est utilisée, de manière analogue à celle décrite dans la demande précitée, pour commander les moyens de court-circuitage 109, par exemple à travers un transistor 115 et peut également être utilisée pour commander le circuit d'excitation 102 de la source d'énergie d'alimentation de l'enroulement primaire du transformateur pour déterminer la fréquence des étincelles dans la mesure où la charge du condensateur 111 étant connue, il est possible d'obtenir une base de temps permettant de déterminer la fréquence des étincelles.

En effet, le condensateur 111 doit être déchargé après chaque étincelle et des moyens de décharge de ce condensateur sont prévus aux bornes de celui-ci. Ces moyens peuvent par exemple être constitués par un transistor de type connu ou par une résistance 116. La décharge du condensateur 111 dans la résistance 116 permet d'obtenir la base de temps mentionnée précédemment et la valeur de cette résistance peut être choisie pour obtenir une fréquence d'étincelles déterminée.

Le fonctionnement général de ce dispositif étant analogue à celui décrit dans la demande précitée, on ne le décrira pas plus détail.

## Revendications

1. Générateur d'allumage haute énergie du type comportant une source d'énergie munie d'un transformateur (104) dont un enroulement secondaire est raccordé à un premier circuit comprenant un condensateur de stockage d'énergie (106), une inductance (107) et une bougie d'allumage (108), en série, une diode de roue libre étant reliée en parallèle aux bornes de l'inductance et de la bougie d'allumage et des moyens de court-circuitage (109) du premier circuit de manière à engendrer des étincelles entre les électrodes de la bougie (108), dans lequel les moyens de court-circuitage comprennent au moins un organe commutateur à semi-conducteur commandé par des moyens de comparaison (110) de la tension aux bornes du condensateur de stockage à une valeur de référence et des moyens de commande (102) de la charge du condensateur à un premier rythme pendant une première période de temps et à un second rythme pendant une seconde période de temps, le second rythme étant supérieur au premier, sont interposés entre la source d'énergie et le premier circuit, caractérisé en ce que les moyens de comparaison (110) de la tension aux bornes du condensateur (106) du premier circuit à la tension de référence, sont reliés aux bornes d'un condensateur (111) d'un second circuit comprenant en série au moins ce condensateur (111) et une impédance (112), connecté aux bornes d'un autre enroulement secondaire (114) du transformateur (104), ce second circuit étant équivalent au premier, de manière que la tension aux bornes du condensateur (111) de ce second circuit soit l'image de celle aux bornes du condensateur (106) du premier circuit.

2. Générateur selon la revendication 1, caractérisé en ce que ladite impédance (112) comprend une inductance et/ou une résistance.

3. Générateur selon la revendication 1 ou 2, caractérisé en ce que des moyens de décharge (116) du condensateur (111) du second circuit sont prévus aux bornes de celui-ci.

4. Générateur selon la revendication 3, caractérisé en ce que les moyens de décharge du condensateur (111) du second circuit comprennent une résistance (116).

5. Générateur selon la revendication 4, caractérisé en ce que les moyens de comparaison (110) sont reliés à la source d'énergie pour commander la fréquence des étincelles, en fonction de la valeur de la résistance (116) de décharge du condensateur (111).

## Claims

1. High-energy ignition generator of the type having an energy source provided with a transformer (104) on which a secondary winding is connected to a first circuit comprising an energy storage capacitor (106), an inductor (107) and an ignition plug (108), in series, a freewheeling diode being connected in parallel to the terminals of the inductor and of the ignition plug, and means (109) for short-circuiting the first circuit so as to generate sparks between the electrodes of the plug (108), in which the short-circuiting means comprise at least one semiconductor switching device controlled by means (110) for comparing the voltage at the terminals of the storage capacitor with a reference value and means (102) for controlling the charge of the capacitor at a first rate for a first period of time and at a second rate for a second period of time, the second rate being higher than the first, are interposed between the energy source and the first circuit, characterised in that the means (110) for comparing the voltage at the terminals of the capacitor (106) in the first circuit with the reference voltage are connected to the terminals of a capacitor (111) in a second circuit comprising in series at least this capacitor (111) and an impedance (112), connected to the terminals of another secondary winding (114) of the transformer (104), this second circuit being equivalent to the first, so that the voltage at the terminals of the capacitor (111) in this second circuit is the image of the voltage at the terminals of the capacitor (106) in the first circuit.

2. Generator according to Claim 1, characterised in that the said impedance (112) comprises an inductor and/or a resistor.

3. Generator according to Claim 1 or 2, characterised in that means (116) for discharging the capacitor (111) in the second circuit are provided at its terminals.

4. Generator according to Claim 3, characterised in that the means (111) for discharging the capacitor in the second circuit comprise a resistor (116).

5. Generator according to Claim 4, characterised in that the comparison means (110) are connected to the energy source in order to control the frequency of the sparks, according to the value of the resistor (116) discharging the capacitor (111).

## Patentansprüche

1. Hochenergie-Zündgenerator des Typs, der eine Energiequelle umfaßt, welche mit einem Transformator (104) versehen ist, dessen eine Sekundärwicklung mit einer ersten Schaltung verbunden ist, die einen Kondensator zum Speichern von Energie (106), eine Spule (107) und eine Zündkerze (108), in Reihe geschaltet, eine Freilaufdiode, die parallel zu den Anschlüssen der Spule und der Zündkerze geschaltet ist, und Kurzschlußeinrichtungen (109) für die erste Schaltung derart, daß Funken zwischen den Elektroden der Kerze (108) erzeugt werden, aufweist, wobei die Kurzschlußeinrichtungen wenigstens ein Halbleiter-Schaltelement aufweisen, das durch Vergleichseinrichtungen (110) für die Spannung an den Anschlüssen des Speicherkondensators mit einer Referenzspannung gesteuert sind, und Steuereinrichtungen (102) für die Ladung des Kondensators auf einen ersten Taktwert während einer ersten Zeitdauer und auf einen zweiten Taktwert während einer zweiten Zeitdauer, wobei der zweite Taktwert über dem ersten liegt, zwischen die Energiequelle und die erste Schaltung gelegt sind, dadurch gekennzeichnet, daß die Vergleichseinrichtungen (110) für die Spannung an den Anschlüssen des Kondensators (106) der ersten Schaltung mit der Referenzspannung mit den Anschlüssen eines Kondensators (111) einer zweiten Schaltung verbunden sind, die in Reihe geschaltet wenigstens diesen Kondensator (111) und eine Impedanz (112) aufweist, angeschlossen an die Anschlüsse einer weiteren Sekundärwicklung (114) des Transformators (104), wobei diese zweite Schaltung äquivalent der ersten ist, derart, daß die Spannung an den Anschlüssen des Kondensators (111) dieser zweiten Schaltung das Bild derjenigen an den Anschlüssen des Kondensators (106) der ersten Schaltung ist.

2. Generator nach Anspruch 1, dadurch gekennzeichnet, daß die Impedanz (112) eine Spule und/oder einen Widerstand aufweist.

3. Generator nach Anspruch 1 oder 2, dadurch gekennzeichnet, daß die Entladungseinrichtungen (116) des Kondensators (111) der zweiten Schaltung an dessen Anschlüssen vorgesehen sind.

4. Generator nach Anspruch 3, dadurch gekennzeichnet, daß die Entladungseinrichtungen des Kondensators (111) der zweiten Schaltung einen Widerstand (116) aufweisen.

5. Generator nach Anspruch 4, dadurch gekennzeichnet, daß die Vergleichseinrichtungen (110) mit der Energiequelle verbunden sind, um die Häufigkeit der Zündungen zu steuern, als Funktion des Wertes des Widerstandes (116) der Entladung des Kondensators (111).
